# EUROPEAN PATENT SPECIFICATION

(11) **EP 1 793 305 B1**
(45) Date of publication and mention of the grant of the patent: **08.06.2011**
(21) Application number: 06125435.5
(22) Date of filing: 05.12.2006
(51) Int. Cl.: G06F 1/18, H05K 7/14

(54) **Method and system for mounting circuit boards to a base board**
Verfahren und System zum Montieren von Leiterplatten auf eine Basisplatte
Procédé et système pour monter des cartes de circuits sur une carte de base

(30) Priority: 05.12.2005 US 293967
(43) Date of publication of application: 06.06.2007
(73) Proprietor: GENERAL ELECTRIC COMPANY, Schenectady, NY 12345 (US)
(72) Inventor: Slaton, David S., Huntsville, AL 35803 (US)
(74) Representative: Illingworth-Law, William Illingworth

(56) References cited:
- US-A- 5 008 778
- US-A- 6 166 917

## Description

### BACKGROUND OF THE INVENTION

The disclosed invention relates to a method and apparatus for modular electronic equipment. More particularly, it relates to methods and apparatus for selectively mounting and securing circuit cards and guide rails within electronic equipment.

Modular construction techniques are widely used to manufacture a variety of electronic equipment. For example, manufacturers of computer equipment use modular construction techniques extensively. With modular techniques, a manufacturer can economically and expeditiously assemble several variations of an electronic device using different combinations of preassembled modular circuits. Additionally, vendors may routinely assemble electronic systems from basic units at a point of sale. Further, end users are usually capable of reconfiguring and/or upgrading modular electronic systems with little effort. In most instances, replacing and/or adding modular electronic circuits in a system requires no more than a simple screwdriver and minimal mechanical skill.

For instance, a conventional personal computer (PC) system generally comprises arrays of prefabricated electronic components mounted on printed circuit boards (PCBs), to form combinations of PCB assemblies. PC manufacturers typically mount a variety of PCB assemblies on a common chassis, along with other components, to form a basic but often incomplete version of a final PC system. Then, in response to a customer request for a particular model having specific capabilities, a manufacturer or vendor adds one or more PCB assemblies and other components to the basic version to produce the appropriate configuration for the model requested. Later, the customer may wish to personally augment the capabilities of or upgrade the PC system. In that case, the manufacturer could provide the customer with the appropriate option cards, which the customer would self-install; see e.g. US 6 166 917.

More specifically, a PC, an embedded computer or other modular system usually contains a main circuit board assembly, called a motherboard, or base board, which typically comprises a relatively large PCB on which many of the device's main components mount. The base board normally mounts on a chassis, which often forms a part of an outer casing or a computer bay that encloses the system components. Finally, unused card connectors and supports, which are equipped to accept certain option cards to be installed at some future time, are also located in a basic system. These unused connectors and supports are ordinarily associated with circuit card guide rails that help installers insert option cards quickly and accurately in their proper locations within the system; see e.g. US 5 008 778.

Card guide rails that are attached to the base board are made to accept a card of a particular width. Alternate cards may be manufactured that have different widths and are therefore not dimensionally compatible with the card guide rails.

Accordingly there is a need in the art to improve the interchangeability of different card sizes within a specific base board.

### BRIEF DESCRIPTION OF THE INVENTION

Disclosed herein is a system for mounting circuit boards in a computer bay as defined in claim 1, comprising inter alia selected pairs of a plurality of distinct rails fastenable in a same position within a common base board to enable receipt therebetween of circuit boards having an infinite number of different widths.

Further disclosed herein is a method of mounting circuit boards to a base board as defined in claim 6, comprising: identifying a particular rail from a plurality of rails that are compatible with a common base board, said identified rail being receptive to a target circuit board; attaching the identified pair of rails to the common base board in position on the base board which are the same for all pairs of rails; engaging the target circuit board with the rail and causing electrical connection of the circuit board with the base board.

### BRIEF DESCRIPTION OF THE DRAWINGS

The following descriptions of embodiments are provided by way of example only and should not be considered limiting in any way. With reference to the accompanying drawings, like elements are numbered alike:
FIG. 1 depicts a perspective view of a base board assembly in accordance with an embodiment of the invention;
FIG. 2 depicts a top view of a carrier board of an embodiment of the invention;
FIG. 3 depicts a partial side view of a peripheral component interface mezzanine card (PMC) assembled to a carrier board and positioned relative to a base board in accordance with an embodiment of the invention;
FIG. 4 depicts a partial side view of a guide rail supporting the carrier board of FIG. 3 relative to a base board;
FIG. 5 depicts a partial front view of the guide rail, carrier board and base board of FIG. 4; and
FIG. 6 depicts a partial front view of a second carrier board and base board in accordance with an embodiment of the invention.

### DETAILED DESCRIPTION OF THE INVENTION

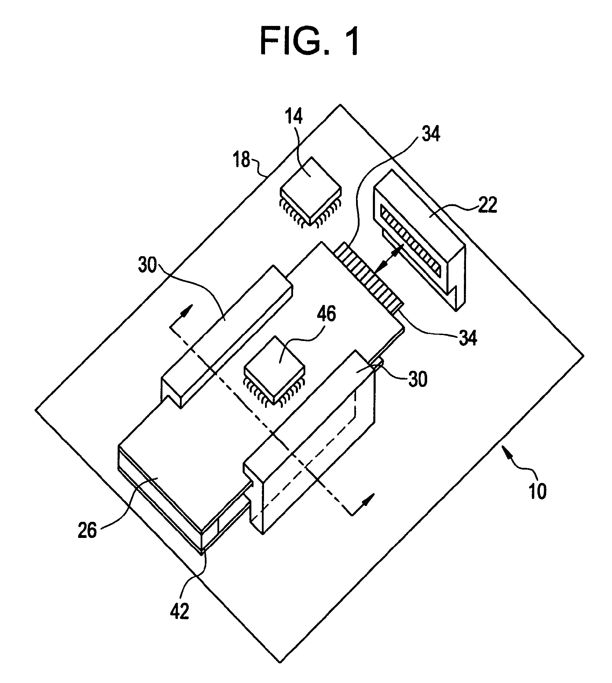

Referring to FIG. 1, a base board assembly 10 may be used in a personal computer (PC), embedded computer or any other computer platform and is mounted within a computer bay (not shown). A base board 18 forms the main circuit board of the base board assembly 10 and supports a plurality of electrical components such as integrated circuit 14 for example as well as cable connectors, switches, display lights, etc. (not shown). An electrical connector 22 supplied on the base board 18 allows for electrically connecting optional carrier circuit boards 26, for example, to expand the capabilities of a basic computer system. Several standards exist for these connectors 22, often referred to as bus connectors, such as: Advanced Mezzanine Card Base Specification (PICMG AMC.0) and Peripheral Component Industry Standard Architecture (PCI-ISA) Passive Backplane Standard (PICMG 1.0), for example. The standards for these bus connectors define the dimensional requirements as well as the electrical requirements for the mating connectors that plug into them, such as connector 34 shown on the carrier board 26.

The carrier boards 26 serve as adaptors for adapting the input and output of the standardized connectors 22 with standard circuit boards known as mezzanine cards 42. Several mezzanine card standards exist that define the dimensional requirements for the mezzanine card 42 and the carrier boards 26 as well as for the electrical requirements for them. The following mezzanine card standards will be used as examples in more detail below: Peripheral Component Interface Mezzanine Card (PMC) and Advanced Mezzanine Card (AMC). Mezzanine card standards allow manufacturers to produce, and for customers to purchase generic mezzanine cards 42 with confidence that the mezzanine cards 42 will be compatible as long as the standards are followed. The use of generic mezzanine cards 42 allows computer manufacturers to keep costs lower than if they had to custom design and manufacture such cards.

Since carrier boards 26 are frequently assembled to the base boards 18 by relatively unskilled people, it is important that the assembly process be as mistake-proof as possible, and that the resulting assembly be robust. Therefore, guide rails 30 are used to align the carrier boards 26 such that the electrical connector 34 of the carrier board 26 is properly aligned with the electrical connectors 22 on the base board 18 prior to and after their mating. The guide rails 30 also support and retain the carrier boards 26 relative to the base board 18 to assure that the connectors 22 and 34 do not move relative to each other, since such movement could result in momentary open circuits which may cause malfunction of the computer system including crashing the system and the potential loss of unsaved data.

The dimensions of mezzanine cards 42 and the associated carrier boards 26, as specified by the standards associated with each mezzanine card 42, create problems of proper fit of the carrier boards 26 with the guide rails 30. For example, if a carrier board is wider than the width provided by the guide rails 30, the carrier board 26 will not assemble to the base board 18. Embodiments of the invention to overcome such conditions will be described below.

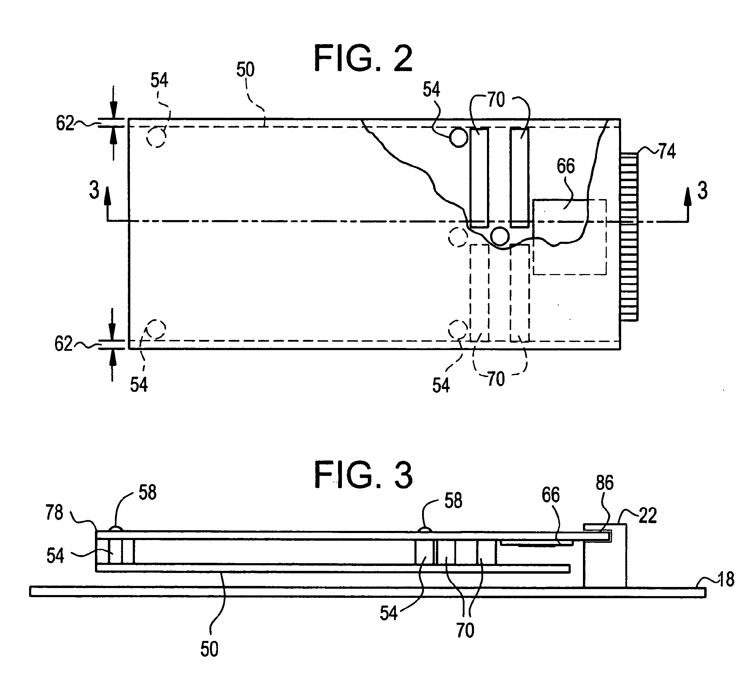

Referring to Figures 2 and 3, a first carrier board 78 (top) assembled to a PMC 50 (bottom) is shown. The PMC 50 has stand-offs 54 that hold the first carrier board 78 a specified distance apart from the PMC 50. Screws 58 thread into holes in the stand-offs 54 through holes in the first carrier board 78. Circuit components can be mounted to both sides of both boards 78 and 50 as long as they stay within predefined volumes specified by the published PMC and AMC standards. The AMC standards call for a component free zone 62 along the length of each side of the card to be at least 2.0 mm. This component free zone 62 provides a margin for safety from handling damage for the components, as well as, assuring available space for the guide rails 30 to interface with the edges of the boards 78.

A bridge circuit 66 is used to adapt a peripheral component interface bus 70 of the PMC 50 to a male peripheral component interface bus 74 located on the end of the first carrier board 78, so that it is compatible with a female peripheral component interface bus 86 of the connector 22.

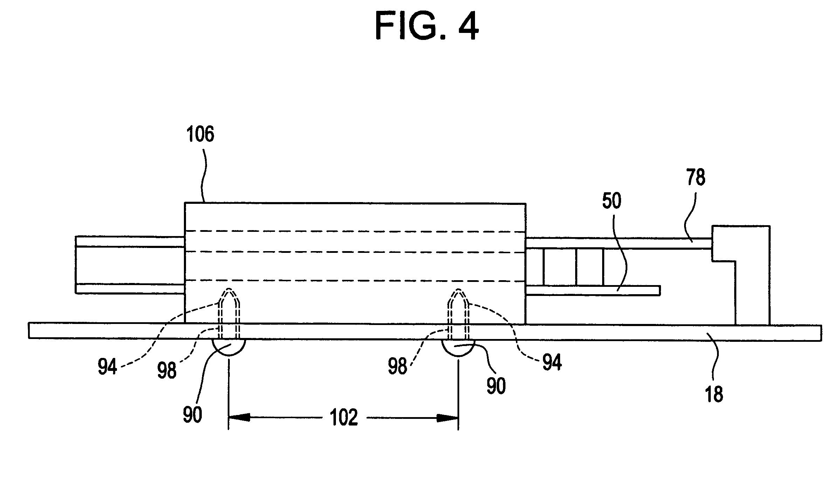

Referring now to FIG. 4, a right side view of the assembly of Figures 2 and 3 are shown with the addition of a first right guide rail 106 that is holding the first carrier board 78 relative to the base board 18. The first right guide rail 106 is fastened to the base board 18 by fasteners which are illustrated in this embodiment as screws 90. The screws 90 are threadably engaged in fastener receptacles illustrated here as holes 94 in the guide rail 106 through holes 98 in the base board 18. A center distance 102 between the base board fastener receiving features illustrated here as holes 98, may be standardized to facilitate ease of design and manufacture of various guide rails 30 and various base boards 18.

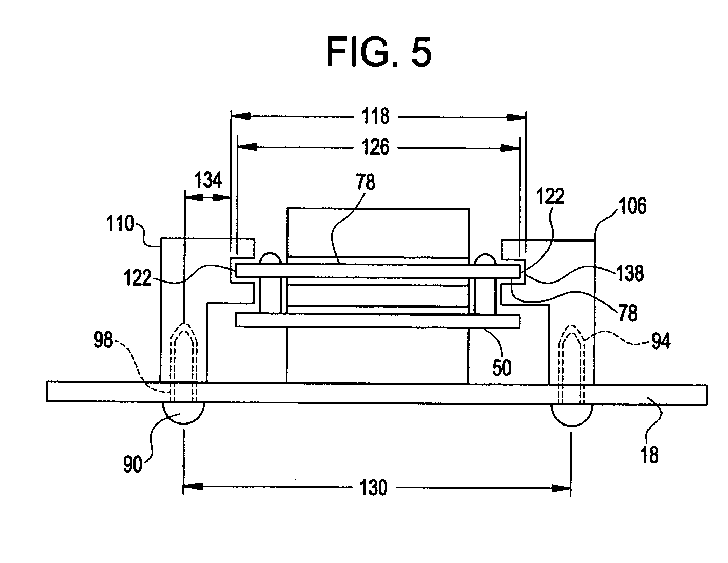

Referring to FIG. 5, a front view of the assembly of FIG 4 is shown with the first right guide rail 106 and a first left guide rail 110 holding the first carrier board 78 to the base board 18 with screws 90. The guide rails 106, 110 are designed and made to form a rail gap width 118, thereby serving as a circuit board engaging feature to frictionally engage the outer lateral edges 122, which form the width of the first carrier board 126. The width of the first carrier board 126 is 77.0 mm in accordance with the PMC 50 width as specified in the PMC standards. If the center-to-center distance 130 of the holes 98 in the base board 18 is 94.0 mm, (an arbitrary dimension chosen by the computer manufacturer) then the guide rails 106, 110 each need an offset dimension 134 of 10.0 mm. That is, the distance from the center of the hole 94 to a first contact surface 138 of the guide rails 106, 110, needs to be 10.0 mm. Thus, when guide rails 106 and 110 are screwed to the base board 18, through holes 98, preformed in the base board 18, the guide rails 106, 110 will be in the proper location to frictionally engage the carrier board 78 during and after installation to the base board 18 and connector 22.

There are a variety of other dimensions associated with the alignment and support of the first carrier board 78 with the base board 18, however, they may remain constant when changing between different mezzanine cards 42 and are therefore not pertinent to embodiments of the invention and are not described here in more detail.

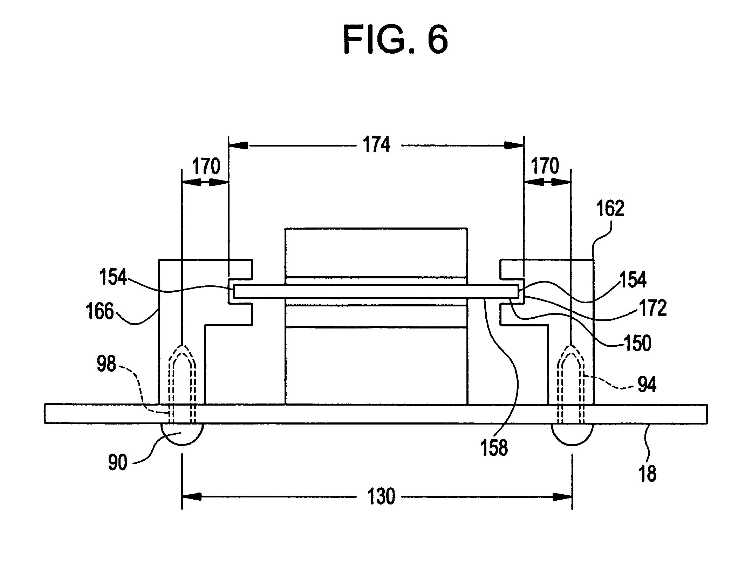

Referring now to FIG. 6, a front view, similar to that of FIG. 5, for an AMC is depicted. The AMC standards specify a card width of 72.9 mm, as opposed to the PMC width of 77.0 mm. Thus, a second carrier board 150 with a width of 72.9 mm between second lateral edges 154 is utilized with AMC 158. Since the same base board 18 is utilized, the center-to-center distance 130 of the holes 98 in the base board 18 remain 94.0 mm apart. Therefore, guide rails 106 and 110 with rail gap width 118 of 77.0 mm will not frictionally engage the second lateral edges 154 of the second carrier board 150 due to the 1.1 mm narrower width of the second carrier board 150, and are therefore not adequate to be utilized with the second carrier board 150. In accordance with an embodiment of the invention a second right guide rail 162, and a second left guide rail 166, are used to accommodate the second carrier board 150. A second guide rail offset dimension 170, of 10.55 mm, between the center of hole 94 and second contact surface 172, is used on guide rails 162 and 166 in order to create a necessary rail gap width 174 of 72.9 mm, thereby serving as a circuit board engaging feature, which matches the width of the second carrier board 178 in accordance with the AMC standards.

It should be appreciated by one skilled in the art that other guide rails in accordance with embodiments of the invention may permit an infinite number of unique carrier board widths to be utilized with a single base board.

Additionally, embodiments of the invention permit the identification of guide rails from a variety of guide rails. To properly engage a specific circuit board with a common base board. Such identification involving finding guide rails that have a specific offset dimension that results in a frictional engagement between the lateral edges of a carrier board with contact surfaces of the guide rails.

Advantages of embodiments of the invention may include: proper fit of guide rails with any carrier board, ease of assembly of guide rails to base boards and flexibility to use an infinite variety of circuit board widths with a common base board.

While the embodiments of the disclosed method and system have been described with reference to exemplary embodiments, it will be understood by those skilled in the art that various changes may be made and equivalents may be substituted for elements thereof without departing from the scope of the embodiments of the disclosed method and system. In addition, many modifications may be made to adapt a particular situation or material to the teachings of the embodiments of the disclosed method and system without departing from the essential scope thereof. Therefore, it is intended that the embodiments of the disclosed method and system not be limited to the particular embodiments disclosed as the best mode contemplated for carrying out the embodiments of the disclosed method and system, but that the embodiments of the disclosed method and system will include all embodiments falling within the scope of the appended claims.

## Claims

1. A system for mounting circuit boards in a computer bay, comprising:
a common base board (18) mounted within a computer bay,
a plurality of distinct rails (106, 110, 162, 166) fastenable within the common base board (18), selected pairs of the plurality of distinct rails (106, 110, 162, 166) being positionable in a same position on the common base board (18) e.g*.* with the same center-to-center distance (130) of fastener receiving features (98) in said common base board, to enable receipt of circuit boards of an infinite number of different widths therebetween.

2. The system of claim 1 wherein the common base board (18) fastener receiving features are holes (98) therethrough.

3. The system of claim 1 wherein the rails (106, 110, 162, 166) are fastened to the base board (18) by fasteners that are screws (90).

4. The system of claim 1 wherein the circuit board (26) is a carrier board (78, 150) to which is mounted a mezzanine card (42).

5. The system of claim 4 wherein the mezzanine card (42) is a peripheral component interface mezzanine card (PMC) (50).

6. A method of mounting circuit boards to a common base board (18), comprising:
identifying a particular pair of rails from a plurality of rails (106, 110, 162, 166) that are compatible with a common base board (18), said identified rail being receptive to a target circuit board;
attaching the identified pair of rails to the common base board (18) in positions on the base board (18) which are the same for all pairs of rails;
engaging the target circuit board with the rails and causing electrical connection of the circuit board (26) with the base board (18).

7. The method of claim 6 further comprising:
attaching said identified rail to the common base board (18) with fasteners.

8. The method of claim 6 wherein the plurality of rails (106, 110, 162, 166) are configured with common fastener receptacles and differing circuit board engaging features.

## Patentansprüche

1. System zum Montieren von Leiterplatten in einem Computereinbaugehäuse, aufweisend:
eine gemeinsame Basisleiterplatte (18), die in dem Computereinbaugehäuse montiert ist;
mehrere unterschiedliche Schienen (106, 110, 162, 166), die in der gemeinsamen Basisleiterplatte (18) befestigt werden können, wobei ausgewählte Paare von den mehreren unterschiedlichen Schienen (106, 110, 162, 166) in einer gleichen Position auf der gemeinsamen Leiterplatte (18) beispielsweise mit dem gleichen Abstand (130) von Mittelpunkt zu Mittelpunkt von Befestigungselemente aufnehmenden Einrichtungen (98) positioniert werden können, um eine Aufnahme von Leiterplatten mit einer unbegrenzten Anzahl unterschiedlicher Breiten dazwischen zu ermöglichen.

2. System nach Anspruch 1, wobei die Befestigungselemente aufnehmenden Einrichtungen der gemeinsamen Basisleiterplatte (18) Löcher (98) durch diese sind.

3. System nach Anspruch 1, wobei die Schienen (106, 110, 162, 166) an der Basisleiterplatte (18) durch Befestigungselemente befestigt sind, die Schrauben (90) sind.

4. System nach Anspruch 1, wobei die Leiterplatte (26) eine Trägerleiterplatte (78, 150) ist, auf welcher eine Tochterkarte (42) montiert ist.

5. System nach Anspruch 4, wobei die Tochterkarte (42) eine Peripheriekomponenten-Schnittstellentochterkarte (PMC) (50) ist.

6. Verfahren zum Montieren von Leiterplatten auf einer gemeinsamen Basisleiterplatte (18), mit den Schritten:
Identifizieren eines speziellen Paares von Schienen von mehreren Schienen (106, 110, 162, 166), die mit einer gemeinsamen Basisleiterplatte (18) kompatibel sind, wobei die identifizierte Schiene eine vorgegebene Leiterplatte aufnimmt;
Befestigen des identifizierten Paares von Schienen an der gemeinsamen Basisleiterplatte (18) in Positionen auf der Basisleiterplatte (18), welche für alle Schienenpaare dieselben sind;
in Eingriff bringen der vorgegebenen Leiterplatte mit den Schienen und Bewirken einer elektrischen Verbindung der Leiterplatte (26) mit der Basisleiterplatte (18).

7. Verfahren nach Anspruch 6, ferner mit dem Schritt:
Anbringen der identifizierten Schiene an der gemeinsamen Basisleiterplatte (18) mit Befestigungselementen.

8. Verfahren nach Anspruch 6, wobei die mehreren Schienen (106, 110, 162, 166) mit gemeinsamen Befestigungselementaufnahmeelementen und unterschiedlichen Leiterplatteneingriffseinrichtungen konfiguriert sind.

## Revendications

1. Système pour monter des cartes de circuits dans une baie d'ordinateur, comprenant :
une carte de base commune (18) montée dans une baie d'ordinateur ;
une pluralité de rails distincts (106, 110, 162, 166) pouvant se fixer dans la carte de base commune (18), des paires choisies de la pluralité de rails distincts (106, 110, 162, 166) pouvant être placées a un même endroit sur la carte de base commune (18), par exemple avec le même entre-axe (130) des moyens de réception (98) de pièces de fixation dans ladite carte de base commune, afin de permettre à des cartes de circuits d'un nombre infini de largeurs différentes d'êtres reçues entre ceux-ci.

2. Système selon la revendication 1, dans lequel les moyens de réception de pièces de fixation dans la carte de base commune (18) sont des trous (98) traversant celle-ci.

3. Système selon la revendication 1, dans lequel les rails (106, 110, 162, 166) sont fixés à la carte de base (18) par des moyens de fixation constitués par des vis (90).

4. Système selon la revendication 1, dans lequel la carte (26) de circuit est une carte support (78, 150) sur laquelle est montée une carte mezzanine (42).

5. Système selon la revendication 4, dans lequel la carte mezzanine (42) est une carte mezzanine PMC (50) servant d'interface pour périphériques.

6. Procédé de montage de cartes de circuits sur une carte de base commune (18), comprenant :
l'identification, parmi une pluralité de rails (106, 110, 162, 166), d'une paire particulière de rails compatibles avec une carte de base commune (18), ladite paire de rails identifiée pouvant recevoir une carte de circuit voulue ;
la fixation de la paire de rails identifiée à la carte de base commune (18) en des emplacements sur la carte de base (18) qui sont les mêmes pour toutes les paires de rails ;
l'engagement de la carte de circuit voulue dans les rails et la création d'une connexion électrique de la carte (26) de circuit avec la carte de base (18).

7. Procédé selon la revendication 6, comprenant en outre :
la fixation de ladite paire de rails identifiée à la carte de base commune (18) à l'aide de moyens de fixation.

8. Procédé selon la revendication 6, dans lequel les rails de la pluralité de rails (106, 110, 162, 166) sont conçus avec des logements communs pour les moyens de fixation et des moyens différents pour l'engagement de la carte de circuit.
